# EUROPEAN PATENT SPECIFICATION

(11) **EP 0 869 563 B1**
(45) Date of publication and mention of the grant of the patent: **02.07.2003**
(21) Application number: 98106181.5
(22) Date of filing: 03.04.1998
(51) Int. Cl.: H01L 39/24, C04B 35/45

(54) **Superconductor; current lead and method of manufacturing the superconductor**
Supraleiter, Stromzuführung und Verfahren zum Herstellen des Supraleiters
Supraconducteur, amenée de courant et procédé de fabrication du supraconducteur

(30) Priority: 04.04.1997 JP 10083397; 23.03.1998 JP 7440998
(43) Date of publication of application: 07.10.1998
(73) Proprietor: SUMITOMO HEAVY INDUSTRIES, LTD., Shinagawa-ku, Tokyo 141-8686 (JP)
(72) Inventor: Ishizuka, Masayuki, Kanagawa (JP); Yanagiya,Tomoyuki, Kanagawa (JP); Yasuhara,Seiji, Kanagawa (JP)
(74) Representative: VOSSIUS & PARTNER

(56) References cited:
- EP-A- 0 449 161
- US-A- 5 250 509

## Description

This invention relates to a superconductor, a current lead and a method of manufacturing the superconductor and, in particular, to a Bi-based superconductor.

Conventionally, a Bi-based superconductor has been used as a current lead. The Bi-based superconductor is mainly classified into Bi-2223 and Bi-2212. Herein, the Bi-2223 is called a high temperature phase while the Bi-2212 is called a low temperature phase. In this event, the Bi-2223 contains three elements of Sr, Ca and Cu other than Bi and has an atomic ratio of Bi : Sr : Ca : Cu which is specified by 2 : 2 : 2 : 3. On the other hand, the Bi-2212 contains three elements of Sr, Ca and Cu other than Bi and has an atomic ratio of Bi : Sr : Ca : Cu which is specified by 2 : 2 : 1 : 2.

Specifically, the Bi-2223 (the high temperature phase) transfers to a superconductive state at a temperature (namely, a critical temperature) of about 110 K while the Bi-2212 (the low temperature phase) transfers to the superconductive state at the critical temperature of about 80 K.

The Bi-2212 generally has the critical temperature (Tc) of 80 K which is slightly higher than the liquid nitrogen temperature (77 K). Consequently, it is practically very difficult to use the Bi-2212 at the liquid nitrogen temperature. However, the characteristic of the Bi-2212 under an applied magnetic field is more excellent at the temperature of 40 K or less than that of the Bi-2223. Therefore, the conventional current lead of the Bi-2212 is preferably used at the low temperature of 40 K or less.

On the other hand, the Bi-2223 has the critical temperature (Tc) of 110 K and therefore, it is practically used at the liquid nitrogen temperature. However, the superconductive characteristic is rapidly reduced when a weak magnetic field is applied thereto.

Conventionally, each of the Bi-2223 and the Bi-2212 has been put into a single-phase to be usable as the current lead.

As mentioned before, although the Bi-2223 of the single-phase has an advantage of the high temperature phase, it has a disadvantage of a low magnetic characteristic. On the other hand, although the Bi-2212 of the single-phase has an advantage of an excellent magnetic characteristic, it has a disadvantage of the low critical temperature.

Therefore, the superconductor having the both advantages of the Bi-2223 and the Bi-2212 has been strongly demanded.

For instance, it is assumed that a current is supplied via a current lead from a power supply to a superconducting magnet in a magnetic field generating apparatus which is placed in a low temperature state. In this event, the current lead of the magnet side is exposed to a low temperature state (for example, 4.2 K) while the current lead of the power supply side is exposed to a high temperature state (for example, 60 K). Further, the current lead must have an excellent magnetic characteristic at the magnet side because the magnetic field which is generated from the magnet is applied to the current lead.

Under this circumstances, it is desirable that the current lead satisfies both of the above-mentioned advantages of the Bi-2223 and the Bi-2212.

To this end, a mixture phase of the Bi-2223 and the Bi-2212 may be taken into consideration so as to satisfy both of the above-mentioned advantages.

However, although the mixture phase of the Bi-2223 and the Bi-2212 conventionally has existed, the conventional mixture phase has not been made from the above viewpoint. Specifically, the conventional mixture phase has been merely evaluated from the viewpoint of the critical temperature.

By the way, it was very difficult to put the Bi-2223 into the single-phase when it was first discovered. Consequently, the Bi-2223 was put into the mixture phase together with the Bi-2212. However, it has recently become easy to put the Bi-2223 into the single-phase by partially substituting Bi by Pb. As a result, the current lead of the Bi-2223 has been realized by the use of the general solid-state reaction process. Specifically, a raw material powder is mixed, molded by the use of a die or a rubber die and reacted by sintering in the above solid-state reaction process.

On the other hand, the Bi-2212 is easily put into the single-phase by melting once and thereafter solidifying slowly. The Bi-2212 of the single-phase is very effective because a wire which is covered with a sheath can be manufactured without the die. Further, the magnetic field dependency of the Bi-2212 at a low temperature is smaller than that of the Bi-2223. Consequently, the Bi-2212 has an excellent superconductive characteristic when it is used at the low temperature and under a strong magnetic field.

However, the casting process or the one direction solidification process is additionally required to form the current lead which is kept in shape. Although the Bi-2212 can be manufactured by the use of these processes, fine control and enough time are necessary to manufacture it. Moreover, it is difficult to fabricate the Bi-2212 by the use of the general solid-state reaction process.

Therefore, the Bi-2223 has been widely used as the current lead in recent years because it can be easily manufactured as compared with the Bi-2212.

As mentioned before, the Bi-2223 has been generally manufactured by partially substituting Bi by Pb. Recently, the current lead has not been formed without the substitution by Pb.

However, it has been reported in traces that the Bi-2223 is formed without the partial substitution by Pb. According to these reports, the approximately single-phase of the Bi-2223 without Pb has been obtained. However, the experiment has been carried out with a short sample in all of these reports. In this event, the evaluation has been merely made by the phase identification due to the X-ray diffraction and by the measurement of the critical temperature. In practice, several tens ampere of current is not given thereto. Therefore, it is impossible to manufacture a large bulk in which the Bi-2223 is put into the approximately single-phase without partially substituting Bi by Pb in the conventional manufacturing method.

Thus, a large current of several hundreds ampere can not be given thereto so far because it is difficult to obtain the Bi-2223 which is put into the approximately single-phase. Further, the Bi-2223 which is put into the single-phase and which is manufactured without the partial substitution by Pb has a larger magnetic field dependency than the Bi-2223 which is partially substituted by Pb. In this point, the above Bi-2223 of the single-phase without Pb has disadvantage.

From the above-mentioned reasons, the Bi-2223 containing Pb of the single-phase has been widely used as the current lead. However, the Bi-2223 of the single-phase gives an adverse influence upon the environment because the Bi-2223 contains Pb which is harmful for the environment.

Moreover, the mixture of the Bi-2223 and the Bi-2212 sometimes generates when the Bi is partially substituted by Pb in accordance with a sintering condition. In this event, an impurity phase, such as Ca₂PbO₄, is precipitated other than the Bi-2212 to disturb the Bi-2223 phase and to largely reduce the superconductive characteristic.

It is therefore an object of this invention to provide a superconductor of a mixture phase of Bi-2223 and Bi-2212 which is capable of satisfying both advantages of the Bi-2223 and the Bi-2212.

It is another object of this invention to provide a superconductor which is applicable to a current lead without Pb.

According to this invention, a superconductor of a mixture phase of Bi-2223 and B-2212 having both advantages can be obtained. Further, the superconductor contains no Pb.

Specifically, the mixture phase of the Bi-2212 and the Bi-2223 has a composition ratio which is specified by 1-X : X. Herein, X falls within the range between 0.4 and 0.8. The mixture phase of the Bi-2212 and Bi-2223 is realized by the following manufacturing process. Namely, raw material powder containing Bi, Sr, Ca and Cu is first prepared. Next, the raw material powder is repeatedly sintered at predetermined sintering temperatures. In this case, the sintering temperatures of second time and later are set lower than that of the first time. Thus, the mixture phase of the Bi-2212 and the Bi-2223 is obtained.

As mentioned above, the superconductor of the mixture phase has the both advantages of the Bi-2212 and the Bi-2223. Consequently, the superconductor of the mixture phase has a relatively high temperature phase and is excellent in magnetic field characteristic. That is, the superconductor has a small magnetic dependency. For instance, the superconductor has a critical current density of 300 A/cm² at a temperature of 77 K and is applicable to a current lead at the practical level.
Fig. 1 is a flow chart showing a manufacturing process according to this invention;
Fig. 2 is a graph showing a result of X-ray diffraction of an obtained sample;
Fig. 3 is a graph showing a critical current at each temperature under an applied magnetic field of 1T;
Fig. 4 is a graph showing a critical current Ic/Ic_{77K} at each temperature under a magnetic field which is normalized by the critical current (Ic_{77K}) under a magnetic field of 0T;
Fig. 5 is a schematic view showing a magnetic field generating apparatus to which a current lead of this invention is applied; and
Fig. 6 is a graph showing performance of the current lead illustrated in Fig. 5.

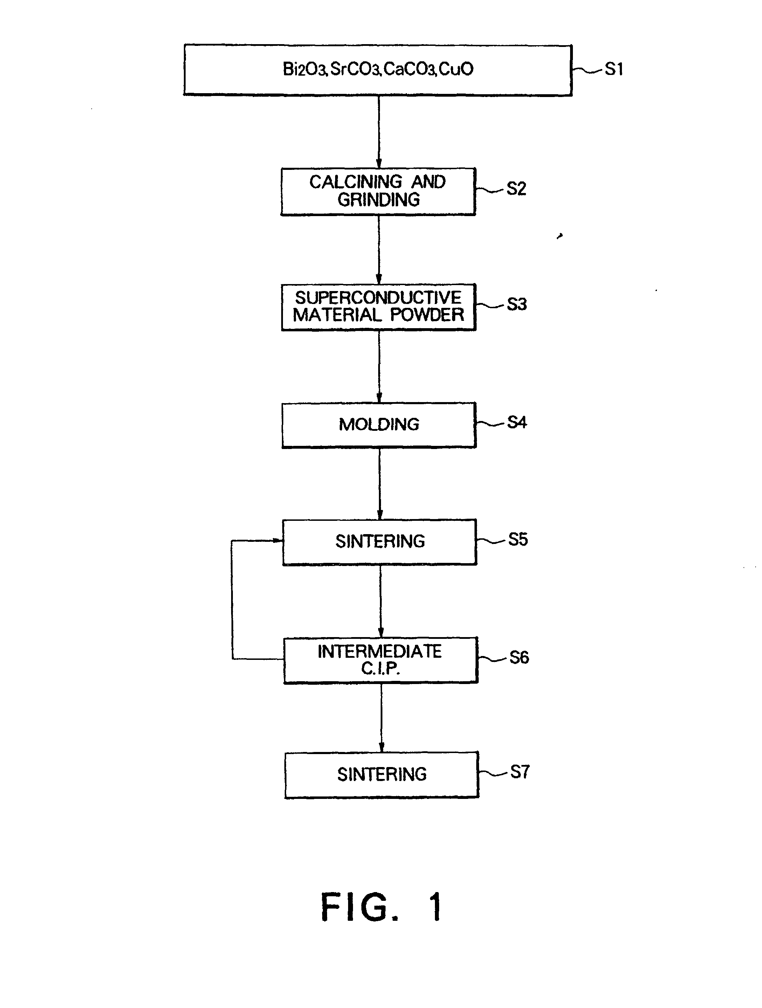

Referring to Fig. 1, description will be made in detail about a manufacturing process according to this invention.

In the flow chart illustrated in Fig. 1, Bi₂O₃, SrCO₃, CaCO₃ and CuO are first prepared as starting materials (step S1). The composition of Bi : Sr : Ca : Cu : O is specified by 2 : 2-X : 2-Y : 3-Z : δ (0.1 < X < 0.3, -0.2 < Y < ±0.2, -0.2 < Z < ± 0.3, δ is arbitrary).

Subsequently, the materials are calcined and ground in a step 2. Consequently, superconductive material powder is obtained in a step S3. Under this condition, the materials are kept at a temperature between 800 °C and 820 °C for 5-15 hr. In this event, a rising and dropping temperature rate is set to 1-3 °C /min while an atmosphere oxygen partial pressure falls within the range between 5% and 15%. In the step of the calcination, the Bi-2212 is mainly formed.

The optimum temperature range becomes narrow except the range of the above-mentioned oxygen partial pressure. Consequently, the temperature must be precisely controlled, for example, at accuracy of 1-2 °C. Otherwise, the Bi-2223 may not be generated due to the slight temperature gap. Therefore, the heat process must be carried out within the range of the above-mentioned oxygen partial pressure.

In a step S4, the powder is molded into an arbitrary shape. For instance, it may be shaped into a cylindrical tube having a desired dimension as the current lead.

Next, a sintering process is carried out in a step S5. Subsequently, an intermediate C.I.P. (cold isostatic press) is performed in a step S6. In this event, the sintering process of the step S5 and the intermediate C.I.P. of the step S6 are repeated several times (for example, 2-3 times).

Herein, the sintering temperature of the first time falls within the range between 850 °C and 870 °C. When the sintering temperature is less than 850 °C, the Bi-2223 phase is not almost generated. When the sintering temperature is more than 870 °C, the material often melts. From these reasons, the sintering temperature of the first time is selected to above-mentioned range.

On the other hand, the sintering temperatures of the second time and later fall within the range between 840 °C and 860 °C. When the sintering temperature is less than 840 °C, a crystal does not almost grow. When the sintering temperature is more than 860 °C, a crystal often melts. Thus, the crystal melts at a lower temperature in the sintering process of the second time than the first time. This is because the Bi-2223 phase exists during the sintering process of the second time. From these reasons, the sintering temperatures of the second time and latter are selected to the above-mentioned range. As mentioned before, the sintering temperatures of the second time and latter are slightly lower than that of the first time according to this invention.

In this case, the mixture phase of the Bi-2223 and the Bi-2212 is mainly made in the sintering process of the first time. Subsequently, the mixture phase is stabilized in the sintering processes of the second time and latter. Namely, a crystal of the mixture phase is grown to improve grain alignment in the sintering processes of the second time and latter.

Further, the retaining time of the sintering temperature is set to 100 hr while the rising and dropping temperature rate is set to 1-3 °C/min.

Moreover, the atmosphere oxygen partial pressure is set to the range between 5% and 15% in the first sintering step. When the atmosphere oxygen partial pressure is less than 5%, an impurity layer without Bi and Ca often generates. When the atmosphere oxygen partial pressure is more than 15%, a generating temperature range of the Bi-2223 phase becomes narrow and therefore, it is difficult to control the sintering temperature. When the oxygen partial pressure is set to the range between 5% and 15%, the Bi-2223 phase easily generates. From these reasons, the oxygen partial pressure is selected to above-mentioned range in the first sintering step.

On the other hand, the partial pressure is substantially equal to the air (about 22%) in the second time and latter. The partial pressure is set to the air to adjust oxygen content in the Bi-2223 phase. In this event, the Bi-2223 is formed by Bi₂Sr₂Ca₂Cu₃O_{X}. Consequently, the characteristic, such as the critical temperature, is largely changed in accordance with the oxygen content (value of X). The critical temperature becomes low and an impurity phase easily generates in the partial pressure except the air. From these reasons, the oxygen partial pressure in the sintering step of the first time is set lower than the air while the partial pressures in the sintering steps of the second time and the latter are set substantially equal to the air according to this invention. Further, the C.I.P. pressure of the intermediate C.I.P. falls within the range between 3000 kgf/cm² and 4000 kgf/cm².

The sintering process is again carried out in a final step S7. In this event, the condition of the sintering process is similar to the sintering process of the second time and latter.

Thus, the sintering process is repeated at least three times. For instance, the sintering process of the first time is carried out at the predetermined sintering temperature to obtain the mixture phase of the Bi-2223 and the Bi-2212. Further, the sintering process of the second time is performed to stabilize the mixture phase at the lower temperature than the first time. In addition, the sintering process of the third time is carried out to further stabilize the mixture phase at the same temperature as the second time.

As mentioned before, the sintering temperatures of the second time and latter are set lower than that of the first time. This is because an impurity phase often takes place when the sintering temperatures of the second time and later are the same as that of the first time.

Thus, the oxide superconductor of the mixture phase of the Bi-2212 and Bi-2223 is obtained by the above-mentioned manufacturing method. In this event, the mixture phase of the Bi-2212 and the Bi-2223 has a composition ratio which is specified by 1-X : X. Herein, X falls within the range between 0.4 and 0.8. The above composition ratio mainly results in the repetition of the sintering step.

Herein, the above composition range is selected from the following reasons.

As mentioned before, the Bi-2223 has the high critical current density Jc at the high temperature (around 77 K) while the Bi-2212 has the high critical current density Jc at the low temperature (40 K or less) under the applied magnetic field (several T or more).

Under the circumstances, when X is less than 0.4, namely, the Bi-2223 is less than 40%, the Bi-2212 is more than 60%. In this case, the critical current density Jc is high at the low temperature and under the applied magnetic field. This is caused by the characteristic of the Bi-2212. However, the critical current density Jc becomes excessively low at the high temperature (77 K). This is caused by the characteristic of the Bi-2223.

On the other hand, when X is more than 0.8, namely, the Bi-2223 is more than 80%, the Bi-2212 is less than 20%. In this event, the critical current density Jc is high at the high temperature (77 K). This is caused by the characteristic of the Bi-2223. However, the critical current density Jc becomes excessively low at the low temperature and under the applied magnetic field. This is caused by the characteristic of the Bi-2212.

Therefore, X is selected within the range between 0.4 and 0.8 to obtain a sufficient critical current density Jc at both the high and the low temperatures in this invention. Specifically, the Bi-2223 falls within the range between 40% and 80% while the Bi-2212 falls within the range between 60% and 20%.

In the superconductor obtained via the above-mentioned manufacturing process, the critical current Ic at the temperature of 77 K is lower than that of the conventional Bi-2223. Herein, Bi is partially substituted by Pb in the conventional Bi-2223. However, the critical current Ic and the critical current density Jc become large to a practical level in a further low temperature. Moreover, the magnetic field dependency becomes small to suppress the deterioration at the low temperature and under the magnetic field. In addition, it is possible to manufacture the current lead and as an application product by the use of the solid-state reaction process which is simpler than the conventional case.

The above-mentioned superconductor may be applicable to a silver sheath wire, a cable, a magnetic shield body and a thin-film in addition to the current lead. In particular, the above-mentioned semiconductor is superior to the conventional one in the application under the magnetic field.

### Example

Subsequently, description will be made about an example according to this invention.

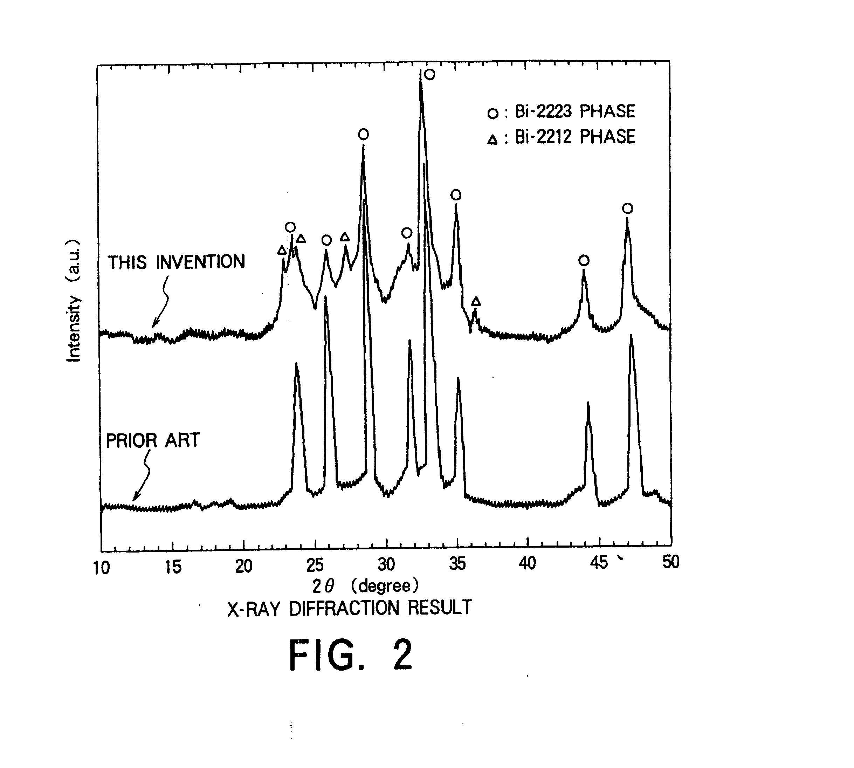

The characteristic of the current lead of the mixture phase of the Bi-2223 and the Bi-2212 is represented in Figs. 2 through 4. In this event, the current lead was manufactured from the raw material having the composition ratio of Bi : Sr : Ca : Cu : O which is specified by 2 : 1.7 : 2.2 : 3.2 : δ (δ is arbitrary) at the first sintering temperature of 860 °C, at the second firing temperature of 850 °C, at the rising and dropping temperature rate of 2.5 °C /min, at the first atmosphere oxygen partial pressure of 8% O₂, at the second atmosphere oxygen partial pressure of 22% O₂ and at the intermediate C.I.P. pressure of 3200 kg/cm² in accordance with the flow chart illustrated in Fig. 1.

In the graph illustrated in Fig. 2 which indicates the X-ray diffraction result of the manufactured sample, the sample had the critical current Ic of about 300 A at the temperature of 77 K and under the magnetic field of 0 T. Further, the sample was shaped into the cylindrical tube of φ 20 mm (diameter) × 100 mm (length) L and the wall thickness of 1.40 mm. In this event, the critical current density Jc was about 320 A/cm².

The graph of the upper side in Fig. 2 corresponds to the current lead of the oxide superconductor according to this invention while the graph of the lower side corresponds to the conventional current lead of the Bi-2223 with Pb. In this case, the triangle mark indicates the Bi-2212 phase while the circle mark indicates the Bi-2223 phase.

The sample according to this invention is the mixture phase having the composition ratio between Bi-2212 and Bi-2223 which is specified by 3 : 7. On the other hand, the conventional sample almost has peaks of the Bi-2223 phase. Consequently, it is found out that the Bi-2223 is the single-phase in the conventional sample.

On the other hand, the superconductor according to this invention is the mixture phase of the Bi-2212 phase and the Bi-2223 phase and has advantages of the both phases. Namely, the critical current density Jc becomes the practical level of about 320 A/cm² in the oxide superconductor according to this invention when the magnetic field of substantially zero is applied thereto at the temperature around 77 K. Further, if the temperature becomes a low temperature of 60 K or less, the critical current density Jc becomes the practical level of 270 A/cm² or more even when a large magnetic field (for example, around 1T) is applied. For instance, the above superconductor can satisfy both the critical current of 300 A and the critical current density Jc of 320 A/cm² or more at the temperature of 60 K and under the magnetic field of 1 T as the practical level.

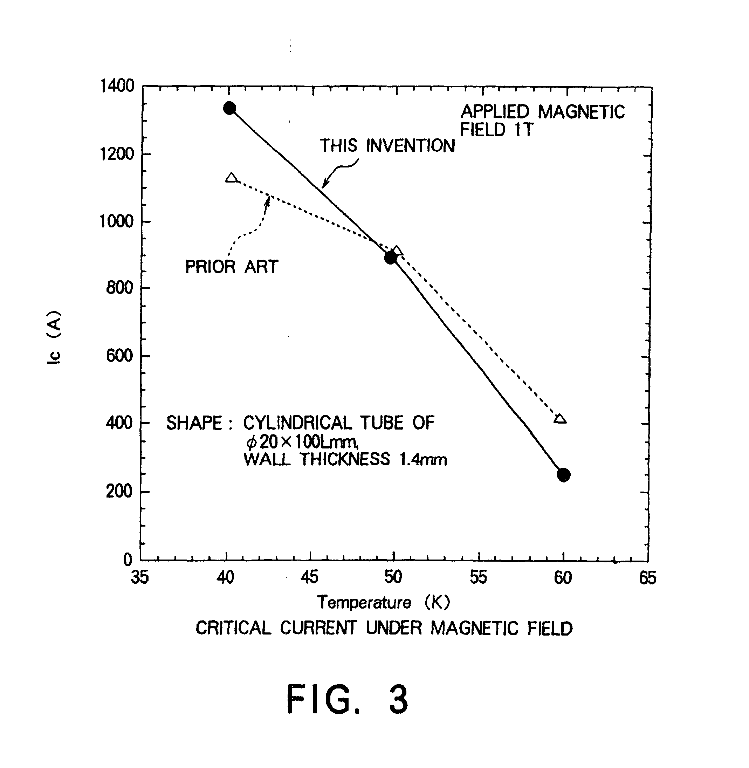

In the graph illustrated in Fig. 3 which indicates the critical current Ic at each temperature under the applied magnetic field 1 T, the solid line in the figure corresponds to the current lead of the oxide superconductor according to this invention while the dot line corresponds to the current lead of the conventional Bi-2223 with Pb.

As illustrated in Fig. 3, the critical current Ic of the current lead according to this invention is 250 A or more at the temperature of 60 K while the current is 900 A or more at the temperature of 50 K under the applied magnetic field of 1 T. Further, the critical current Ic is 1300 A or more at the temperature of 40 K under the applied magnetic field of 1 T. The superconductor having these values is sufficiently applicable for the current lead.

As compared with the critical current Ic of the conventional current lead, the current lead according to this invention is substantially equal to the conventional one at the temperature of 50 K while the current lead of this invention is higher at the temperature of 40 K than the conventional one.

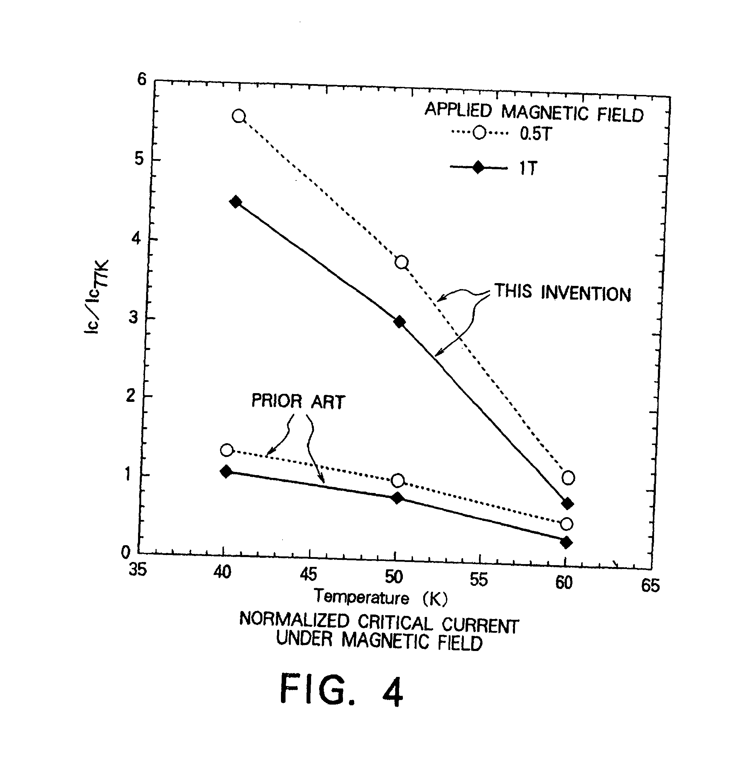

In the graph illustrated in Fig. 4 which indicates the critical current Ic/Ic _{77K} under the magnetic field which is normalized by the critical current Ic _{77K} at the temperature of 77 K and under the magnetic field of 0 T, the case of this invention and the conventional case (the conventional Bi-2223) are represented in the figure, respectively.

Herein, the critical current is 300 A in the current lead of this invention at the temperature of 77 K and under the magnetic field of 0 T while the current is 1100 A in the conventional case under the same condition. Further, the value of the Ic/Ic_{77K} is about 4.5 in the current lead of this invention at the temperature of 40 K and under the magnetic field of 1 T while the value is about 1.0 in the conventional case under the same condition.

In this event, the absolute value of the critical current is 1350 A in this invention while the value is 1100 A in the conventional case. Under such a condition, the critical current of the current lead according to this invention is larger than the conventional case.

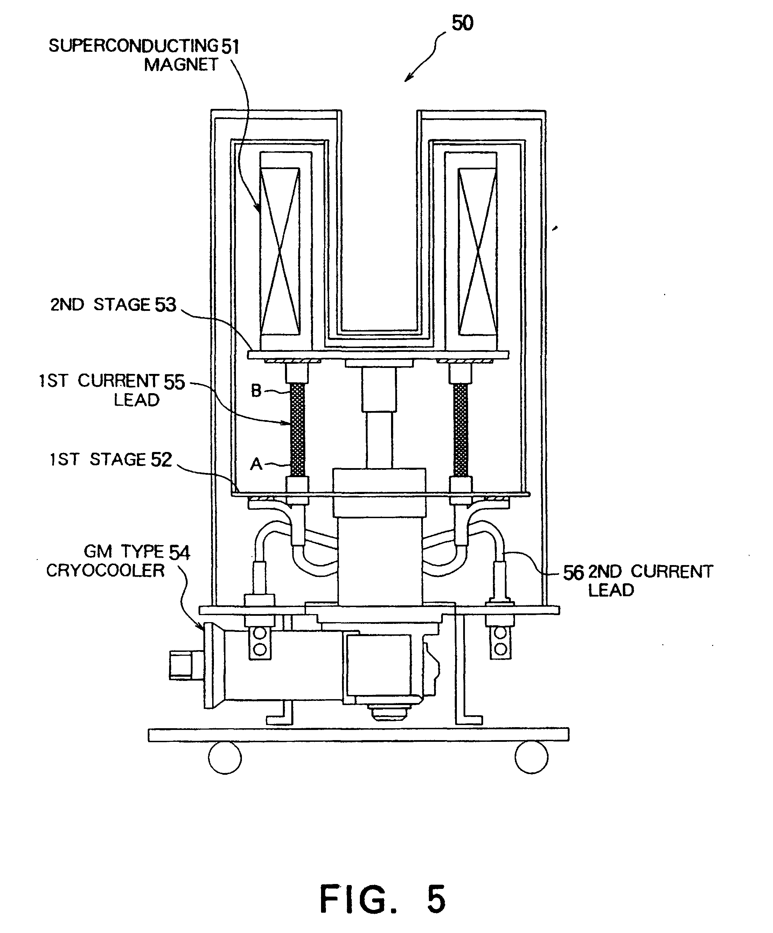

For instance, the current lead formed by the mixture phase of the Bi-2223 and Bi-2212 is applied to a magnetic field generating apparatus illustrated in Fig. 5.

The magnetic field generating apparatus 50 mainly includes a superconducting magnet 51 of Nb₃Sn, a first stage 52, a second stage 53 and Gifford-Macmahon (GM) type cryocooler 54. The superconducting magnet 51 is attached to the second stage 53 and cooled down to 7 K by the cryocooler 54. The super conducting magnet 51 generates the magnetic field of 2.5 T at the current of 100 A and has a bore diameter of 50 mm at the room temperature. Further, a first current lead 55 which is formed by the mixture phase of the Bi-2223 and the Bi-2212 is connected between the first stage 52 and the second stage 53. In this case, the first current lead 55 is shaped to the cylindrical tube having a diameter of 20 mm and a length of 150 mm. Moreover, the first current lead 55 has the critical current of 300 A and the critical current density of 300 A/cm² at 77K.

In addition, a second current lead 56 which is made by copper is connected between the first stage 52 and the cryocooler 54. In this event, the first stage 52 has a temperature around 45 K. Thus, the first current lead 55 is connected to the first stage 52 at a higher temperature end (45 K) and is connected to the second stage 53 at a lower temperature end (7 K).

With such a structure, the current is supplied to the first stage 52 via the second current lead 56 and is supplied from the first stage 52 to the superconducting magnet 51 via the first current lead 55. In this case, when the superconducting magnet 51 generates the magnetic field of 2.5 T, the higher temperature end A of the first current lead 55 is exposed to the magnetic field of 0.07 T while the lower temperature end B of the first current lead 55 is exposed to the magnetic field of 0.2T.

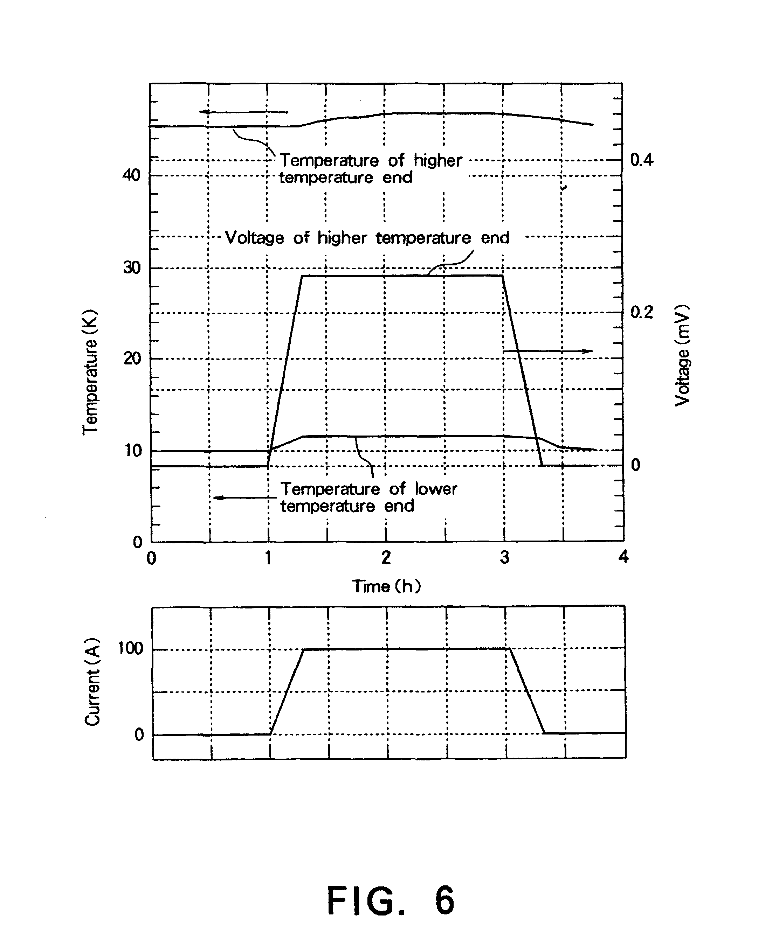

Subsequently, the performance of the first current lead 55 is shown in Fig. 6 when the first current lead 55 is applied to the magnetic field generating apparatus 50 illustrated in Fig. 5. The temperature of the higher temperature end A, the temperature of the lower temperature end B and the voltage of the higher temperature end A are represented in Fig. 6, respectively. Herein, the voltage of the higher temperature end A indicates contact resistance of the first current lead 55.

When the current is zero, the temperatures of both ends A and B of the first current lead 55 are 10 K and 45 K, respectively. When the current is raised up to 100 A, the magnetic field of 2.5 T is generated in a center of the bore of the superconducting magnet 51. Consequently, the first current lead 55 is exposed to 0.2T at the lower temperature end B and to 0.07 T at the higher temperature end A. When the current of 100 A is supplied, the voltage of 0.25 mV is applied to the higher temperature end A of the first current lead 55. This voltage is caused by the contact resistance not by quench of the first current lead 55.

As illustrated in Fig. 6, when the current is supplied to the superconducting magnet 51, the temperatures of the higher temperature end A and the lower temperature end B are raised up. However, when the current is retained, the temperatures are kept constant.

The current was practically supplied to the superconducting magnet 51 for two hours via the first current lead 55. Consequently, it has been confirmed that the temperature and the voltage of the first current lead 55 are kept almost constant and the magnetic field stably generates. Thus, the first current lead 55 of the above-mentioned mixture phase is sufficiently practical as the current lead of the magnetic field generating apparatus 50 illustrated in Fig. 5.

## Claims

1. A superconductor which contains Bi, Sr, Ca and Cu and which has a first composition formed by a first phase of Bi-2212 and a second composition formed by a second phase of Bi-2223 coexisting with the first phase where the Bi-2212 has a first atomic ratio of Bi : Sr : Ca : Cu which is specified by 2 : 2 : 1 : 2 while the Bi-2223 has a second atomic ratio of Bi : Sr : Ca : Cu which is specified by 2 : 2 : 2 : 3, wherein:
a composition ratio between the first and the second compositions is represented by 1-X : X, where X falls within the range between 0.4 and 0.8.

2. A superconductor as claimed in claim 1, which is substantially free from Pb.

3. A superconductor as claimed in claim 1 or 2, which has a critical current density exceeding 100 A/cm² at a temperature not higher than a boiling point of liquid nitrogen.

4. A current lead which is formed by a superconductor of claim 1,2 or 3.

5. A method of manufacturing a superconductor according to any one of claims 1-4, comprising the steps of:
preparing raw material powder containing Bi, Sr, Ca and Cu; and
repeatedly sintering the raw material powder at predetermined sintering temperatures;
the sintering temperatures in the sintering steps of second time and later being set lower than that of the first time.

6. A method as claimed in claim 5, wherein:
the sintering temperature of the first time falls within the range between 850 °C and 870 °C while the sintering temperatures of the second time and latter fall within the range between 840 °C and 860 °C.

7. A method as claimed in claim 5 or 6, wherein:
each of the sintering steps is carried out under a sintering atmosphere having a predetermined oxygen partial pressure;
the oxygen partial pressure in the sintering step of the first time being set lower than the air while the oxygen partial pressures in the sintering steps of the second time and later being set substantially equal to the air.

8. A method as claimed in claim 7, wherein:
the oxygen partial pressure in the sintering step of the first time falls within the range between 5% and 15% while the oxygen partial pressures in the sintering steps of the second time and later are set to approximately 22% of the total sintering atmosphere pressure.

9. A method as claimed in claim 5, 6, 7 or 8, wherein: the sintering step of the first time is carried out in order to obtain a mixture phase of Bi-2212 and Bi-2223 where the Bi-2212 has a first atomic ratio of Bi : Sr : Ca : Cu which is specified by 2 : 2 : 1 : 2 while the Bi-2223 has a second atomic ratio of Bi : Sr : Ca : Cu which is specified by 2 : 2 : 2 : 3, and the sintering steps of the second time and latter are repeated so as to stabilize the mixture phase.

10. A method of manufacturing a superconductor according to any one of claims 1-4, comprising the steps of:
preparing raw material powder containing Bi, Sr, Ca and Cu;
calcining the raw material powder;
grinding the raw material powder to form a superconductor powder;
molding the ground superconductor powder to a preselected shape;
sintering the molded superconductor powder; and
performing cold isostatic press for the sintered superconductor powder;
the sintering step being repeated at predetermined sintering temperatures;
the sintering temperatures in the sintering steps of second time and later being set lower than that of the first time.

11. A method as claimed in claim 10, wherein:
each of the sintering steps is carried out under a firing atmosphere having a predetermined oxygen partial pressure;
the oxygen partial pressure in the sintering step of the first time being set lower than the air while the oxygen partial pressures in the sintering steps of the second time and latter being set substantially equal to the air.

12. A method as claimed in claim 12, 13, or 14, wherein: the calcining step is carried out in order to obtain Bi-2212 where the Bi-2212 has a first atomic ratio of Bi : Sr : Ca : Cu which is specified by 2 : 2 : 1 : 2.

13. A method as claimed in claim 12, wherein:
the sintering step of the first time is carried out in order to obtain a mixture phase of the Bi-2212 and Bi-2223 where the Bi-2223 has a second atomic ratio of Bi : Sr : Ca : Cu which is specified by 2 : 2 : 2 : 3, and
the sintering steps of the second time and latter are repeated so as to stabilize the mixture phase.

14. A method as claim in claim 9 or 13, wherein:
the mixture phase has a composition ratio which is represented by 1-X : X, where X falls within the range between 0.4 and 0.8.

15. A method as claimed in any one of claims 5 to 14, wherein: the sintering temperature of the second time is substantially equal to that of the third time.

## Patentansprüche

1. Supraleiter, der Bi, Sr, Ca und Cu enthält und eine erste Zusammensetzung aufweist, die durch eine erste Phase von Bi-2212 gebildet wird, und eine zweite Zusammensetzung, die durch eine zweite Phase von Bi-2223 gebildet wird, die mit der ersten Phase koexistent ist, wobei die Bi-2212-Phase ein erstes Atomverhältnis Bi:Sr:Ca:Cu aufweist, das durch 2:2:1:2 spezifiziert ist, während die Bi-2223-Phase ein zweites Atomverhältnis Bi:Sr:Ca:Cu aufweist, das durch 2:2:2:3 spezifiziert ist,
wobei ein Zusammensetzungsverhältnis zwischen der ersten und der zweiten Zusammensetzung durch 1-X:X dargestellt wird und X im Bereich zwischen 0,4 und 0,8 liegt.

2. Supraleiter nach Anspruch 1, der im wesentlichen kein Pb aufweist.

3. Supraleiter nach Anspruch 1 oder 2 mit einer kritischen Stromdichte von mehr als 100 A/cm² bei einer Temperatur, die nicht höher ist als der Siedepunkt von flüssigem Stickstoff.

4. Stromzuleitung, die aus einem Supraleiter nach Anspruch 1, 2 oder 3 gebildet wird.

5. Verfahren zum Herstellen eines Supraleiters nach einem der Ansprüche 1 bis 4 mit den Schritten:
Vorbereiten eines Ausgangsmaterialpulvers, das Bi, Sr, Ca und Cu enthält; und
wiederholtes Sintern des Ausgangsmaterialpulvers bei vorgegebenen Sintertemperaturen;
wobei die Sintertemperaturen im zweiten und in weiteren Sinterschritten auf niedrigere Werte eingestellt werden als im ersten Sinterschritt.

6. Verfahren nach Anspruch 5, wobei
die Sintertemperatur im ersten Sinterschritt im Bereich zwischen 850°C und 870°C liegt, während die Sintertemperaturen im zweiten und in weiteren Sinterschritten im Bereich zwischen 840°C und 860°C liegen.

7. Verfahren nach Anspruch 5 oder 6, wobei
jeder der Sinterschritte in einer Sinteratmosphäre mit einem vorgegebenen Sauerstoff-Partialdruck ausgeführt wird;
der Sauerstoff-Partialdruck im ersten Sinterschritt niedriger eingestellt wird als derjenige von Luft, während die Sauerstoff-Partialdrücke im zweiten und in den weiteren Sinterschritten im wesentlichen auf denjenigen von Luft eingestellt werden.

8. Verfahren nach Anspruch 7, wobei
der Sauerstoff-Partialdruck im ersten Sinterschritt im Bereich zwischen 5% und 15% liegt, während der Sauerstoff-Partialdruck im zweiten und in den weiteren Sinterschritten auf etwa 22% des Sinteratmosphären-Gesamtdrucks eingestellt wird.

9. Verfahren nach Anspruch 5, 6, 7 oder 8, wobei
der erste Sinterschritt ausgeführt wird, um eine Mischphase von Bi-2212 und Bi-2223 zu erhalten, wobei die Bi-2212-Phase ein erstes Atomverhältnis von Bi:Sr:Ca:Cu aufweist, das durch 2:2:1:2 spezifiziert ist, während die Bi-2223-Phase ein zweites Atomverhältnis von Bi:Sr:Ca:Cu aufweist, das durch 2:2:2:3 spezifiziert ist; und
der zweite und die weiteren Sinterschritte wiederholt werden, um die Mischphase zu stabilisieren.

10. Verfahren zum Herstellen eines Supraleiters nach einem der Ansprüche 1 - 4 mit den Schritten:
Vorbereiten eines Ausgangsmaterialpulvers, das Bi, Sr, Ca und Cu enthält;
Kalzinieren des Ausgangsmaterialpulvers;
Mahlen des Ausgangsmaterialpulvers, um ein Supraleiterpulver herzustellen;
Formen des gemahlenen Supraleiterpulvers in eine vorgegebene Form;
Sintern des geformten Supraleiterpulvers; und
kalt-isostatisches Pressen des gesinterten Supraleiterpulvers;
wobei der Sinterschritt bei vorgegebenen Sintertemperaturen wiederholt wird; und
die Sintertemperaturen im zweiten und in den weiteren Sinterschritten auf niedrigere Werte eingestellt werden als im ersten Sinterschritt.

11. Verfahren nach Anspruch 10, wobei
jeder der Sinterschritte in einer Feuerungsatmosphäre mit einem vorgegebenen Sauerstoff-Partialdruck ausgeführt wird;
der Sauerstoff-Partialdruck im ersten Sinterschritt auf einen niedrigeren Wert eingestellt wird als derjenige von Luft, während der Sauerstoff-Partialdruck im zweiten und in den weiteren Sinterschritten demjenigen von Luft im wesentlichen gleicht.

12. Verfahren nach Anspruch 10 oder 11, wobei
der Kalzinierungsschritt ausgeführt wird, um die Bi-2212-Phase zu erhalten, wobei die Bi-2212-Phase ein erstes Atomverhältnis von Bi:Sr:Ca:Cu aufweist, das durch 2:2:1:2 spezifiziert ist.

13. Verfahren nach Anspruch 12, wobei
der erste Sinterschritt ausgeführt wird, um eine Mischphase aus Bi-2212 und Bi-2223 zu erhalten, wobei die Bi-2223-Phase ein zweites Atomverhältnis von Bi:Sr:Ca:Cu aufweist, das durch 2:2:2:3 spezifiziert ist; und
der zweite und die weiteren Sinterschritte wiederholt werden, um die Mischphase zu stabilisieren.

14. Verfahren nach Anspruch 9 oder 13, wobei
die Mischphase ein Zusammensetzungsverhältnis aufweist, das durch 1-X:X dargestellt wird, wobei X im Bereich zwischen 0,4 und 0,8 liegt.

15. Verfahren nach einem der Ansprüche 5 bis 14, wobei
die Sintertemperatur im zweiten Sinterschritt derjenigen im dritten Sinterschritt im wesentlichen gleicht.

## Revendications

1. Supraconducteur qui contient Bi, Sr, Ca et Cu et qui présente une première composition formée d'une première phase de Bi-2212 et une seconde composition formée d'une seconde phase de Bi-2223 coexistant avec la première phase où le Bi-2212 présente un premier rapport atomique de Bi : Sr : Ca : Cu qui est spécifié par 2 : 2 : 1 : 2 alors que le Bi-2223 présente un second rapport atomique de Bi : Sr : Ca : Cu qui est spécifié par 2 : 2 : 2 : 3, dans lequel :
un rapport de composition entre les première et seconde compositions est représenté par 1-X : X, où X tombe dans la plage entre 0,4 à 0,8.

2. Supraconducteur selon la revendication 1, qui est pratiquement dépourvu de Pb.

3. Supraconducteur selon la revendication 1 ou 2, qui présente une densité de courant critique dépassant 100 A/cm² à une température qui n'est pas supérieure à un point d'ébullition de l'azote liquide.

4. Conducteur de courant qui est formé d'un supraconducteur selon la revendication 1, 2 ou 3.

5. Procédé de fabrication d'un supraconducteur conforme à l'une quelconque des revendications 1 à 4, comprenant les étapes consistant à :
préparer une poudre de matière brute contenant Bi, Sr, Ca et Cu, et
fritter de façon répétitive la poudre de matière brute à des températures de frittage prédéterminées,
les températures de frittage dans les étapes de frittage de la seconde fois et suivantes étant réglées à une valeur inférieure à celle de la première fois.

6. Procédé selon la revendication 5, dans lequel :
la température de frittage de la première fois tombe dans la plage entre 850 °C à 870 °C alors que les températures de frittage de la seconde fois et des suivantes tombent à l'intérieur de la plage entre 840 °C à 860 °C.

7. Procédé selon la revendication 5 ou 6, dans lequel :
chacune des étapes de frittage est exécutée sous une atmosphère de frittage présentant une pression partielle d'oxygène prédéterminée,
la pression partielle d'oxygène dans l'étape de frittage de la première fois étant réglée à une valeur inférieure à celle de l'air alors que les pressions partielles de l'oxygène dans les étapes de frittage de la seconde fois et des suivantes sont réglées de façon sensiblement égale à celle de l'air.

8. Procédé selon la revendication 7, dans lequel :
la pression partielle de l'oxygène dans l'étape de frittage de la première fois tombe dans la plage entre 5 % à 15 % alors que les pressions partielles de l'oxygène dans les étapes de frittage de la seconde fois et des suivantes sont réglées à approximativement 22 % de la pression totale de l'atmosphère de frittage.

9. Procédé selon la revendication 5, 6, 7 ou 8, dans lequel : l'étape de frittage de la première fois est exécutée de manière à obtenir une phase de mélange du Bi-2212 et du Bi-2223 où le Bi-2212 présente un premier rapport atomique de Bi : Sr : Ca : Cu qui est spécifié par 2 : 2 : 1 : 2 alors que le Bi-2223 de la composition Bi : Sr : Ca : Cu présente un second rapport atomique qui est spécifié par 2 : 2 : 2 : 3, et
les étapes de frittage de la seconde fois et des suivantes sont répétées de façon à stabiliser la phase du mélange.

10. Procédé de fabrication d'un supraconducteur selon l'une quelconque des revendications 1 à 4, comprenant les étapes consistant à :
préparer une poudre de matière brute contenant Bi, Sr, Ca et Cu,
calciner la poudre de matière brute,
broyer la poudre de matière brute pour former une poudre de supraconducteur,
mouler la poudre de supraconducteur broyée suivant une forme présélectionnée,
fritter la poudre de supraconducteur moulée, et
exécuter un pressage isostatique à froid pour la poudre de supraconducteur frittée,
l'étape de frittage étant répétée à des températures de frittage prédéterminées,
les températures de frittage des étapes de frittage de la seconde fois et des suivantes étant réglées à une valeur inférieure à celle de la première fois.

11. Procédé selon la revendication 10, dans lequel :
chacune des étapes de frittage est exécutée sous une atmosphère de brûlage présentant une pression partielle de l'oxygène prédéterminée,
la pression partielle de l'oxygène dans l'étape de frittage de la première fois étant réglée à une valeur inférieure à celle de l'air alors que les pressions partielles de l'oxygène dans les étapes de frittage de la seconde fois et des suivantes sont réglées de façon sensiblement égale à celle de l'air.

12. Procédé selon la revendication 10 ou 11, dans lequel : l'étape de calcination est exécutée de manière à obtenir Bi-2212 où le Bi-2212 présente un premier rapport atomique de Bi : Sr : Ca : Cu qui est spécifié par 2 : 2 : 1 : 2.

13. Procédé selon la revendication 12, dans lequel :
l'étape de frittage de la première fois est exécutée de manière à obtenir une phase de mélange du Bi-2212 et du Bi-2223 où le Bi-2223 de la composition Bi : Sr : Ca : Cu présente un second rapport atomique qui est spécifié par 2 : 2 : 2 : 3, et
les étapes de frittage de la seconde fois et des suivantes sont répétées de façon à stabiliser la phase du mélange.

14. Procédé selon la revendication 9 ou 13, dans lequel :
la phase de mélange présente un rapport de composition qui est représenté par 1-X : X, où X tombe dans la plage entre 0,4 à 0,8.

15. Procédé selon l'une quelconque des revendications 5 à 14, dans lequel : la température de frittage de la seconde fois est sensiblement égale à celle de la troisième fois.
